# DEMANDE DE BREVET EUROPEEN

(11) **EP 1 265 291 A1**
(43) Date de publication de la demande: **11.12.2002**
(21) Numéro de dépôt: 01202211.7
(22) Date de dépôt: 08.06.2001
(51) Int. Cl.: H01L 27/146, H04N 3/15

(54) **Capteur d'image CMOS et procédé permettant d'opérer un capteur d'image CMOS avec une dynamique accrue**

(71) Demandeur: EM Microelectronic-Marin SA, 2074 Marin (CH)
(72) Inventeur: Doering, Elko, 2572 Mörigen (CH); Grupp, Joachim, 2073 Enges (CH)
(74) Mandataire: Ravenel, Thierry Gérard Louis

(57) **Abrégé**

Il est décrit un capteur d'image réalisé en technologie CMOS ainsi qu'un procédé permettant d'opérer un tel capteur d'image. Ce capteur comporte une pluralité de pixels (50) comportant chacun un élément photo-détecteur (PD) produisant des porteurs de charge en proportion de son illumination et un moyen de stockage (C1) susceptible d'être couplé et découplé de l'élément photo-détecteur à un instant déterminé afin de mémoriser, sur un noeud mémoire (B) du pixel, un signal de mesure représentatif des porteurs de charge produits par ledit élément photo-détecteur durant une phase d'exposition.

Chaque pixel comprend au moins un transistor MOS (M1 ; M3) connecté en série par ses terminaux de drain ou de source à l'élément photo-détecteur, et ce transistor est configuré de manière à ce qu'il fonctionne au moins partiellement en faible inversion de sorte que le pixel présente, lors de la phase d'exposition, une réponse logarithmique pour des niveaux d'illumination supérieurs à un niveau d'illumination déterminé.

Cette réponse au moins partiellement logarithmique permet d'augmenter la dynamique du capteur.

## Description

La présente invention concerne généralement un capteur d'image intégré et un procédé permettant d'opérer un tel capteur d'image intégré. Plus particulièrement, la présente invention concerne un capteur d'image intégré en technologie CMOS et un procédé permettant d'opérer un tel capteur d'image CMOS avec une dynamique accrue. De tels capteurs d'image CMOS sont en particulier destinés à la réalisation de dispositifs photographiques et vidéos intégrés.

Grâce aux technologies actuelles d'intégration, il est possible de réaliser sous forme intégrée un dispositif opérationnel de prise d'images. Un tel dispositif intégré de prise d'images incorpore, sur une même puce, un composant photo-détecteur formé d'un ensemble d'éléments photo-détecteurs organisés typiquement sous forme de matrice, et un composant de traitement destiné à assurer les opérations de prise d'images et de lecture de l'information capturée par le composant photo-détecteur.

Traditionnellement, les dispositifs intégrés de prise d'images font appel à des techniques de transfert de charge. Selon ces techniques, des charges photo-générées sont collectées et transférées d'une manière déterminée. Les techniques de transfert de charge les plus communes utilisent des composants CCD ("charge-coupled devices") ou des composants CID ("charge injection devices"). Bien que ces dispositifs employant ces composants aient trouvé de nombreuses applications commerciales, ceux-ci présentent néanmoins de sérieux désavantages. En particulier, ces composants font appel à des techniques de fabrication non standards, et en particulier incompatibles avec les processus de fabrication CMOS standards. Des tels composants sont donc des obstacles, en termes de coût et de facilité de fabrication, à l'intégration totale de capteurs d'images.

En complément des techniques susmentionnées, un concept a été développé autour de l'utilisation de jonctions p-n semi-conducteurs comme éléments photo-détecteurs, ces jonctions étant communément dénommées photodiodes. L'avantage essentiel de tels éléments est leur parfaite compatibilité avec les processus de fabrication CMOS standard. On connaît ainsi de l'art antérieur, notamment du document "A Random Access Photodiode Array for Intelligent Image Capture" de Orly Yadid-Pecht, Ran Ginosar et Yosi Shacham Diamand, IEEE Transactions On Electron Devices, Vol. 38, no. 8, août 1991, pp. 1772-1780, incorporé ici par référence, des solutions faisant appel à des photodiodes comme éléments photo-détecteurs.

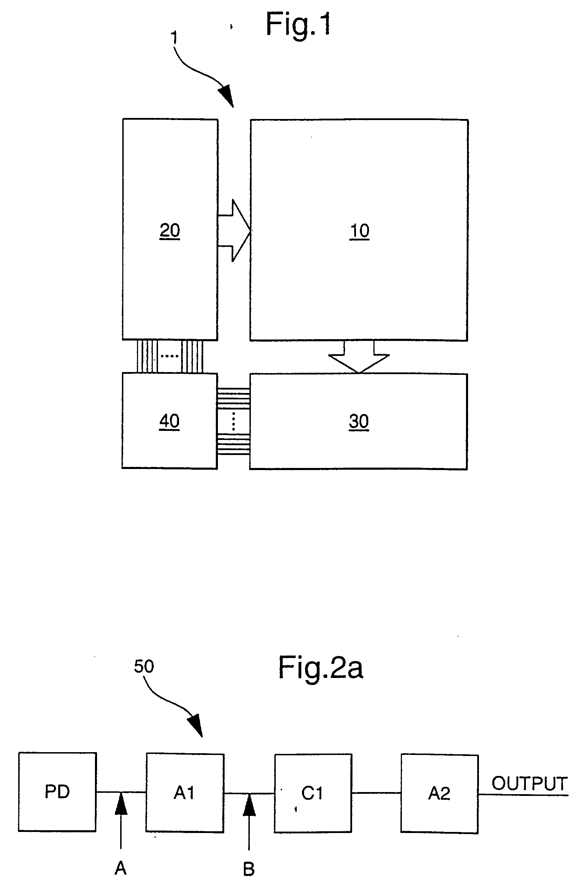

Ce document décrit ainsi un capteur d'image intégré en technologie CMOS sous forme d'une unique puce. L'architecture de ce capteur, qui est similaire à celle de mémoires RAM, est illustrée à la figure 1. Ce capteur, indiqué généralement par la référence numérique 1, comporte une matrice 10 de pixels agencés en M lignes et N colonnes. Cette matrice 10 occupe la majeure partie de la surface du capteur. La lecture d'un pixel particulier de la matrice 10 est effectué par l'adressage de la ligne et de la colonne correspondantes. A cet effet, le capteur comprend en outre un circuit d'adressage de ligne 20 couplé aux lignes de la matrice 10 et un bus de sortie 30 couplé aux colonnes de la matrice 10, tous deux commandés par un circuit de commande 40.

Chaque pixel de la matrice 10 possède une structure conforme à l'illustration de la figure 2a. Ce pixel, indiqué généralement par la référence numérique 50 dans la figure 2a, comporte un élément photo-détecteur PD, un premier étage A1, un moyen de stockage C1 et un second étage A2. L'élément photo-détecteur PD est formé d'une photodiode polarisée inverse qui opère typiquement par collecte des électrons photo-générés durant une période dite d'intégration. Le premier étage A1 est un circuit de type "sample-and-hold" assurant l'échantillonnage, à un temps déterminé, de la valeur de tension présente aux bornes de la photodiode PD. Cette valeur échantillonnée est mémorisée dans le moyen de stockage C1 qui est typiquement formé d'une capacité. On notera que la valeur de la tension stockée sur la capacité C1 dépend de la fonction de transfert du premier étage A1 et en particulier du rapport entre la valeur de la capacité de la photodiode PD et de la capacité du moyen de stockage C1. Le second étage A2 permet quant à lui d'assurer la lecture de la tension échantillonnée mémorisée dans le moyen de stockage C1. La structure schématiquement décrite dans la figure 2a permet avantageusement la séparation des processus de détection et de lecture.

La structure générale du pixel illustrée dans la figure 2a permet ainsi de réaliser une fonction dite d'obturation électronique permettant d'exposer simultanément tous les pixels du capteur et de mémoriser, dans chaque pixel, le signal représentatif de cette exposition en vue d'une lecture ultérieure. Au moyen de cette structure, on peut ainsi réaliser un capteur d'image susceptible de permettre l'acquisition d'instantanés (ou « snap-shots ») d'une scène, c'est-à-dire un capteur parfaitement adapté pour l'acquisition d'images d'objets en mouvement relatif par rapport au capteur.

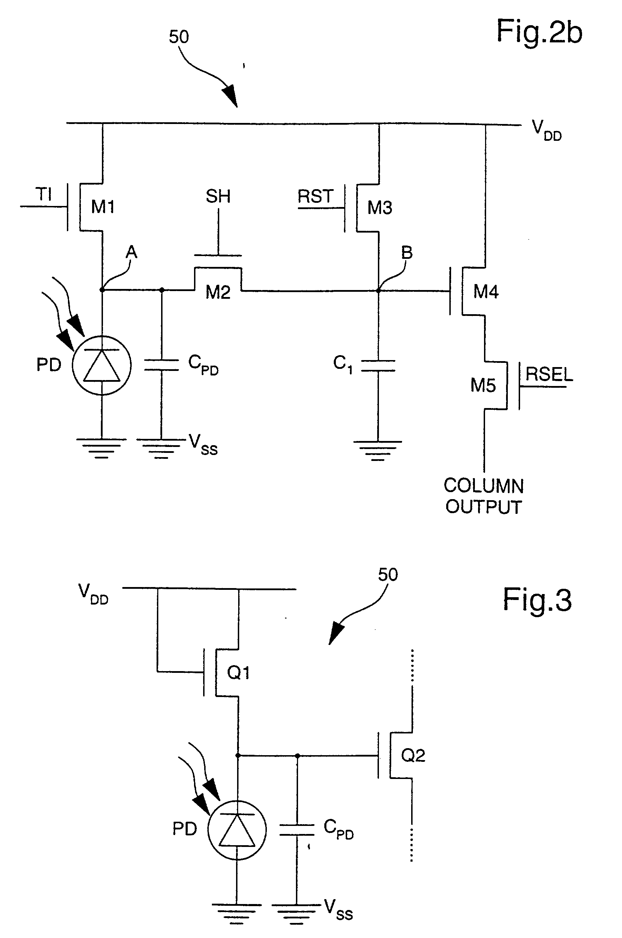

Diverses réalisations sont envisagées et présentées dans le document de l'art antérieur susmentionné. La figure 2b montre en particulier l'une de ces réalisations dans laquelle le pixel 50 comporte la photodiode PD polarisée inverse et cinq transistors M1 à M5 de type n-MOS. Chaque pixel 50 comporte un noeud mémoire, désigné B, formé d'une capacité (capacité C1) et protégé de la lumière, par exemple par une couche de protection métallique.

Selon l'article susmentionné, le pixel opère selon un mode d'intégration et le transistor M1 assure l'initialisation de la photodiode PD à une tension déterminée avant chaque période d'intégration. Le transistor M2 assure l'échantillonnage de la charge accumulée par la photodiode PD et la mémorisation du signal ainsi échantillonné sur le noeud mémoire B. Ce transistor M2 assure par ailleurs un isolement ou découplage de la photodiode PD et du noeud mémoire B. Le transistor M3 assure notamment l'initialisation du noeud mémoire B à une tension déterminée. Le transistor M4 est un transistor à "source suiveuse" ("source follower transistor") et le transistor M5 est un transistor de sélection de ligne et assure, lors du processus de lecture, le transfert de la tension du transistor M4 sur un bus de sortie commun à tous les pixels dans une colonne. Les signaux appliqués sur cette structure comprennent une tension d'alimentation haute V_{DD} et une tension d'alimentation basse V_{SS} formant masse, un premier signal d'initialisation TI, un signal de couplage SH, un second signal d'initialisation RST, et un signal de sélection de ligne RSEL.

Une première borne de la photodiode PD est connectée à la masse V_{SS} et l'autre borne est connectées aux terminaux de source des transistors M1 et M2 dont les terminaux de grille sont respectivement commandés par les signaux TI et SH. Le noeud de connexion entre la photodiode PD et les terminaux de sources des transistors M1 et M2 sera désigné par la référence A dans la suite de la description. Les terminaux de drain des transistors M1, M3 et M4 sont connectés à la tension d'alimentation haute V_{DD}. Le second signal d'initialisation RST est appliqué sur le terminal de grille du transistor M3. Le terminal de source du transistor M3, le terminal de drain du transistor M2 et le terminal de grille du transistor M4 sont connectés ensemble au noeud mémoire B du pixel. Le terminal de source du transistor M4 est connecté, via le transistor de sélection de ligne M5, au bus de sortie commun à tous les pixels dans une colonne. Le signal de sélection de ligne RSEL est appliqué sur le terminal de grille du transistor M5.

On notera que la plupart des capteurs d'images CMOS adoptent une technique d'exposition dite de « rolling shutter », c'est-à-dire que l'exposition est effectuée ligne après ligne. Cette exposition non simultanée conduit inévitablement à une distorsion de l'image, en particulier lors de l'acquisition d'une image d'un objet en mouvement.

La structure de pixel illustrée dans les figures 2a et 2b est typiquement opérée selon un mode d'intégration, c'est-à-dire que les éléments photo-détecteurs sont tout d'abord initialisés à une tension déterminée puis soumis à une illumination durant une période de temps déterminée, les charges produites par les éléments photo-détecteurs étant accumulées ou intégrées durant cette période. Selon ce mode de fonctionnement, la réponse du pixel peut être qualifiée de linéaire. Un désavantage de ce mode de fonctionnement réside dans le fait que la dynamique du pixel est réduite.

De nombreuses applications requièrent des capteurs d'images possédant une grande dynamique. Afin d'accroître la dynamique d'un capteur d'image, il est déjà connu d'utiliser des capteurs comprenant des pixels possédant une réponse de type logarithmique. La figure 3 présente un schéma d'un tel pixel agencé pour présenter une réponse logarithmique. Ce pixel, indiqué globalement par la référence numérique 50, comprend une photodiode PD polarisée inverse, et un premier et second transistor Q1 et Q2 de type n-MOS. Une première borne de la photodiode PD est connectée à la masse V_{SS} et son autre borne au terminal de source du transistor Q1. Les terminaux de grille et de drain du transistor Q1 sont connectés ensemble à un potentiel d'alimentation V_{DD}. Dans cette configuration, le transistor Q1, branché en résistance, est traversé par le courant de faible intensité (de l'ordre du fA au nA) généré par la photodiode PD et opère en conséquence en faible inversion (on dit également que ce transistor opère en conduction infraseuil ou « subthreshold conduction »). La tension V_{OS} aux bornes de la photodiode PD, au noeud de connexion entre la photodiode PD et le transistor Q1, présente de la sorte une dépendance logarithmique par rapport au courant généré sous l'effet d'une illumination. Le transistor Q2 forme un étage de lecture du pixel (similaire au transistor M4 de la figure 2b) et son terminal de grille est connecté au noeud de connexion entre la photodiode PD et le transistor Q1.

La configuration illustrée en figure 3 est dite à conversion continue, c'est-à-dire que la tension V_{OS}, qui est une fonction logarithmique du courant généré par la photodiode PD, est directement convertie et est représentative de l'illumination du pixel. Contrairement aux structures de pixels à réponse dite linéaire, les charges produites par l'élément photo-détecteur ne sont pas « intégrées» durant une période dite d'intégration ou d'exposition de durée déterminée.

Un problème de la configuration illustrée à la figure 3 réside dans le fait que la variation de tension produite en fonction de l'illumination tend à être relativement faible (de l'ordre de quelques centaines de mV). Ceci rend difficile l'utilisation d'un tel pixel pour l'implémentation d'un capteur ayant un rapport signal sur bruit élevé, en particulier pour des niveaux d'illumination réduits. En outre, le temps de réponse de ce type de pixel devient très long pour de faibles illuminations où le courant photo-généré est faible.

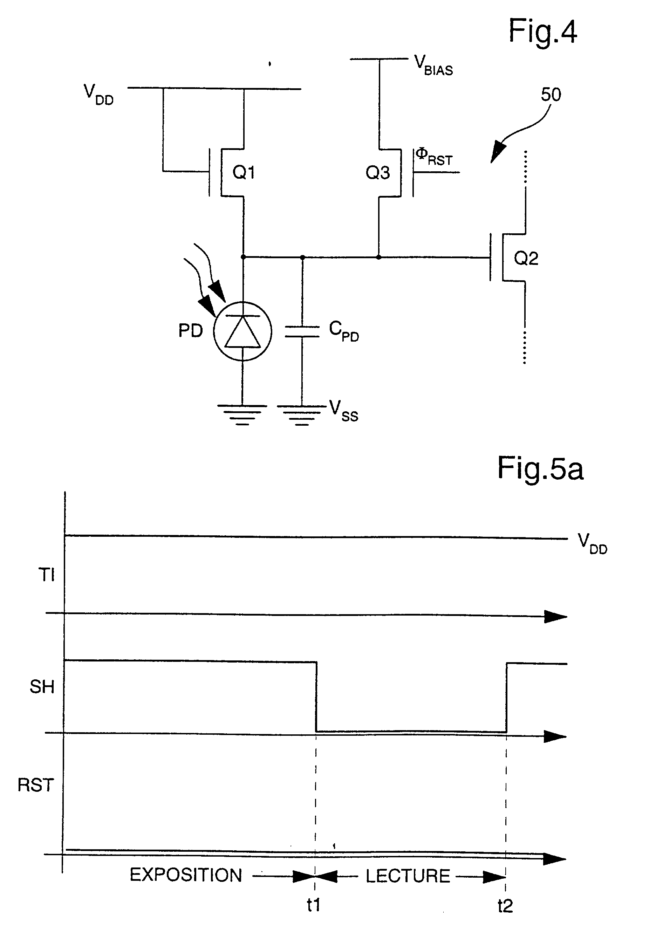

Il a ainsi également été proposé dans le document « Wide-Dynamic-Range Pixel with Combined Linear and Logarithmic Response and Increased Signal Swing », Eric C. Fox et consorts, Sensors and Camera Systems for Scientific, Industrial and Digital Photography Applications, Proceedings of SPIE Vol. 3965 (2000), pp. 4-10, une structure de pixel présentant une réponse combinée linéaire-logarithmique. Un schéma de ce pixel est illustré dans la figure 4.

A la différence du pixel de la figure 3,-ce pixel comporte en outre un troisième transistor Q3 connecté par son terminal de source au noeud de connexion entre la photodiode PD et le premier transistor Q1 et, par son terminal de drain, à un potentiel dit d'initialisation ou reset V_{BIAS}. L'état de conduction du transistor Q3 est commandé par le signal Φ_{RST} appliqué sur son terminal de grille. Le potentiel d'initialisation V_{BIAS} est supérieur au potentiel d'alimentation V_{DD} de sorte que lorsque le signal Φ_{RST} est à l'état logique haut, la tension V_{OS} aux bornes de la photodiode PD est amenée à une tension telle que la tension grille-source du transistor Q1 est inférieure à la tension nécessaire pour permettre la conduction infraseuil de ce transistor Q1.

Dès lors que le signal Φ_{RST} est ramené à un niveau logique bas, la tension V_{OS} diminue linéairement sous l'effet de l'illumination jusqu'à ce que la tension grille-source du transistor Q1 atteigne un niveau tel que ce transistor opère en faible inversion. Au-delà de ce niveau, la réponse du pixel devient logarithmique de manière analogue à ce qui à déjà été mentionné en référence à la figure 3.

De même que la structure illustrée dans la figure 3, la tension V_{OS} aux bornes de la photodiode PD est directement appliquée sur l'entrée de l'étage de lecture. Il n'est donc pas possible d'utiliser directement ces structures pour réaliser un capteur d'image à obturation électronique adapté pour l'acquisition d'instantanés ou « snap-shots ».

Un but de la présente invention est ainsi de proposer un procédé permettant d'opérer un capteur d'image à obturation électronique du type susmentionné possédant une structure de pixel conforme aux illustrations des figures 2a et 2b et ceci avec une dynamique accrue.

Afin de répondre à ce but, la présente invention a pour objet un procédé permettant d'opérer un capteur d'image CMOS dont les caractéristiques sont énoncées dans la revendication 1.

La présente invention à également pour objet un capteur d'image CMOS dont les caractéristiques sont énoncées dans la revendication indépendante 15.

Des modes de réalisations avantageux de la présente invention font l'objet des revendications dépendantes.

Selon certains modes de réalisation particuliers de l'invention, il est ainsi proposé un capteur d'image ainsi que divers procédés permettant d'opérer un tel capteur d'image à obturation électronique de sorte que chaque pixel présente une réponse combinée linéaire-logarithmique.

Selon un autre mode de réalisation particulièrement avantageux, il est également proposé un capteur d'image ainsi qu'un procédé permettant d'opérer un tel capteur à obturation électronique de sorte que chaque pixel présente une réponse combinée linéaire-logarithmique ainsi qu'une sensibilité accrue.

Un avantage de la présente invention réside dans le fait que la dynamique d'un capteur d'image à obturation électronique utilisant notamment une structure de pixel telle que la structure illustrée dans la figure 2b est augmentée.

D'autres caractéristiques et avantages de la présente invention apparaîtront plus clairement à la lecture de la description détaillée qui suit, faite en référence aux dessins annexés donnés à titre d'exemples non limitatifs et dans lesquels :
- la figure 1, déjà présentée, illustre schématiquement l'architecture conventionnelle d'un capteur d'image CMOS ;
- les figures 2a et 2b, déjà présentées, illustrent respectivement un schéma de principe et un schéma détaillé d'une structure connue d'un pixel du capteur d'image CMOS de la figure 1 ;
- la figure 3, déjà présentée, montre un schéma détaillé d'une structure de pixel connue à réponse logarithmique ;
- la figure 4, déjà présentée, montre un schéma détaillé d'une structure de pixel connue à réponse combinée linéaire-logarithmique ;
- les figures 5a à 5c montrent des diagrammes illustrant des première, deuxième et troisième variantes du procédé selon l'invention permettant d'opérer la structure de la figure 2b de sorte qu'elle présente, outre la fonction d'obturation électronique, une réponse de type logarithmique ;
- les figures 6a et 6b montrent des diagrammes illustrant des quatrième et cinquième variantes du procédé selon l'invention permettant d'opérer la structure de la figure 2b de sorte qu'elle présente, outre la fonction d'obturation électronique, une réponse combinée linéaire-logarithmique ;
- les figures 7a et 7b illustrent des première et deuxième variantes de la structure de pixel de la figure 2b pouvant être opérées de sorte qu'elles présentent une réponse combinée linéaire-logarithmique ;
- les figures 8a et 8b montrent des diagrammes illustrant des sixième et septième variantes du procédé selon l'invention permettant respectivement d'opérer les structures de pixels des figures 7a et 7b de sorte qu'elles présentent une réponse combinée linéaire-logarithmique ;
- la figure 9a montre un diagramme illustrant une huitième variante particulièrement avantageuse du procédé selon l'invention permettant d'opérer la structure de la figure 2b de sorte qu'elle présente, outre la fonction d'obturation électronique, une réponse combinée linéaire-logarithmique ainsi qu'une sensibilité accrue ; et
- la figure 9b montre les niveaux de potentiels engendrés par les tensions appliquées sur les grilles des transistors de la structure de la figure 2b opérée selon la huitième variante illustré dans la figure 9a.

On décrira maintenant, au moyen des figures, diverses variantes du procédé selon la présente invention permettant d'opérer le pixel 50 de la figure 2b de sorte qu'il présente un réponse logarithmique pour des niveaux d'illumination supérieurs à un niveau d'illumination déterminé.

On comprendra que les diverses variantes de procédé selon la présente invention ne sont pas limitées à l'opération d'une structure telle que la structure illustrée à la figure 2b, mais peuvent être appliquées de manière analogue à tout type de structure se présentant schématiquement sous la forme de la structure illustrée à la figure 2a, c'est-à-dire une structure comportant un élément photo-détecteur et un moyen de stockage susceptible d'être couplé à l'élément photo-détecteur à un instant déterminé afin de produire et mémoriser un signal de mesure représentatif des porteurs de charge produits par l'élément photo-détecteur au cours de l'exposition, cette structure présentant au moins un transistor MOS connecté (directement ou indirectement) par son terminal de drain ou de source à l'élément photo-détecteur. La structure de la figure 2b constitue néanmoins une structure simple et particulièrement avantageuse. A ce titre, on constatera que le transistor M1 ou le transistor M3 peut être configuré pour fonctionner en mode de faible inversion, le transistor M1 étant directement connecté à la photodiode PD alors que le transistor M3 est connecté à cette photodiode PD via le transistor de couplage M2. On verra que cette possibilité d'utiliser indépendamment le transistor M1 ou M3 assure une grande flexibilité d'utilisation.

La figure 5a montre ainsi un diagramme temporel de l'évolution des signaux de commande TI, SH et RST appliqués respectivement sur les transistors M1, M2 et M3 de la structure de pixel de la figure 2b illustrant une première variante du procédé selon l'invention. Selon cette première variante, le transistor M1 est branché en configuration de résistance, le terminal de grille de ce transistor M1 étant branché en continu à la tension d'alimentation V_{DD}. Le signal TI est ainsi maintenu à la valeur de tension appliquée sur le drain du transistor M1. Selon cette première variante, le signal de couplage SH est maintenu à l'état logique haut de manière à coupler le noeud mémoire B au terminal de source du transistor M1 (noeud A) durant l'exposition. La tension présente sur le noeud mémoire B est donc représentative de la tension présente au noeud A aux bornes de la photodiode PD. Le signal RST appliqué sur la grille du transistor M3 est ici maintenu en continu à un niveau logique bas de manière à rendre non-conducteur ce transistor M3 et ainsi découpler le noeud mémoire B de la tension d'alimentation V_{DD}.

Durant l'exposition, le pixel se comporte ainsi de manière analogue à la structure illustrée dans la figure 3, c'est-à-dire que le transistor M1 se comporte comme une résistance de haute impédance traversée par le courant générée par la photodiode PD. Le courant généré étant de l'ordre du fA au nA, le transistor M1 opère en mode de faible inversion et la réponse de ce pixel est ainsi également logarithmique.

L'exposition se prolonge jusqu'au stade (instant t1) où le signal SH est amené à un niveau bas découplant ainsi le noeud mémoire B de la photodiode PD, le signal de mesure étant alors mémorisé sur la capacité de stockage C1. L'opération de lecture peut alors être entreprise au moyen des transistors M4 et M5. Une nouvelle phase d'exposition débute par le repassage du signal SH à son niveau haut (instant t2).

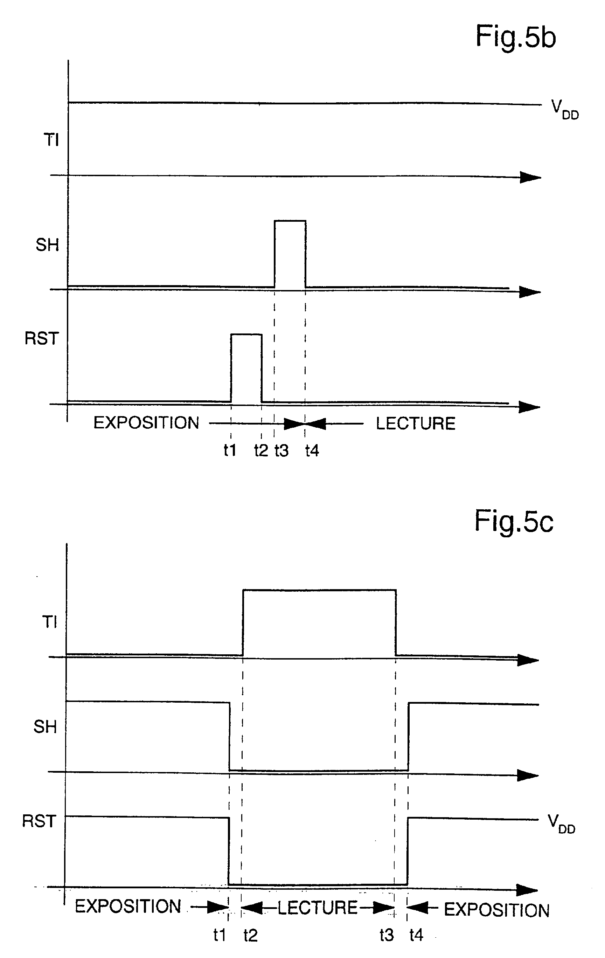

La figure 5b montre un diagramme temporel de l'évolution des signaux de commande TI, SH et RST appliqués sur la structure de pixel de la figure 2b illustrant une deuxième variante du procédé selon l'invention permettant d'opérer le pixel de sorte qu'il présente une réponse logarithmique. Selon cette deuxième variante, le transistor M1 est également branché en configuration de résistance, le terminal de grille de ce transistor M1 étant branché à la tension d'alimentation V_{DD}. Le signal TI est donc maintenu en continu à la valeur de tension appliquée sur le drain du transistor M1. Le signal de couplage SH est ici maintenu à l'état logique bas de manière à découpler le noeud mémoire B du terminal de source du transistor M1 (noeud A) durant l'exposition. Comme illustré dans le diagramme de la figure 5b, le signal SH est brièvement pulsé à l'état logique haut (instants t3 à t4) de manière à échantillonner et mémoriser le signal de mesure sur le noeud mémoire B. Avant le passage du signal SH à l'état haut, le signal RST appliqué sur le transistor M3 est également brièvement pulsé à l'état logique haut (instants t1 à t2) de manière à initialiser le noeud mémoire B à une tension d'initialisation déterminée.

Contrairement à la variante illustrée dans la figure 5a, l'opération de lecture selon cette deuxième variante peut être entreprise en parallèle à une exposition ultérieure, dès lors que le signal de mesure a été mémorisé sur le noeud mémoire B.

La figure 5c montre un diagramme temporel de l'évolution des signaux de commande TI, SH et RST appliqués sur la structure de pixel de la figure 2b illustrant une troisième variante du procédé selon l'invention permettant également d'opérer le pixel de sorte qu'il présente une réponse logarithmique. Selon cette troisième variante, et contrairement aux variantes précédentes, le transistor M3 est branché en configuration de résistance durant l'exposition, le terminal de grille de ce transistor M3 étant branché à la tension d'alimentation V_{DD}. Le signal RST est donc maintenu, durant la phase d'exposition, à la valeur de tension appliquée sur le drain du transistor M3. Le signal de couplage SH est maintenu à l'état logique haut de manière à coupler le noeud mémoire B au terminal de source du transistor M1 (noeud A) durant l'exposition. Le signal TI est quant à lui maintenu au niveau logique bas durant l'exposition.

L'exposition se prolonge jusqu'à l'instant t1 où le signal de couplage SH ainsi que le signal RST sont amenés à un niveau bas afin d'isoler le noeud mémoire B et mémoriser le signal de mesure sur ce noeud. Idéalement, les signaux SH et RST devraient être amenés simultanément au niveau bas à l'instant t1. Etant donné que la commutation simultanée des transistors M2 et M3 est difficile à réaliser en pratique, on s'arrangera préférablement pour que le signal RST passe tout d'abord au niveau bas suivi par le signal SH. Ceci induirait un léger offset sur le signal de mesure présent sur le noeud mémoire B qui pourra être considéré et toléré lors de la lecture.

En outre, il convient préférablement de faire passer le signal TI appliqué sur le terminal de grille du transistor M1 à un niveau haut dès lors que le signal de mesure a été mémorisé sur le noeud mémoire B (instant t2 dans la figure 5c). En effet, la photodiode PD étant découplée, celle-ci continue à produire des porteurs de charge qui pourraient éventuellement perturber le signal présent sur le noeud mémoire B. Le transistor M1 opéré de la sorte permet ainsi de drainer les porteurs de charge produits par la photodiode PD.

A partir de l'instant t2, l'opération de lecture peut être entreprise au moyen des transistors M4 et M5. Au terme de l'opération de lecture le signal TI est ramené à son niveau bas (instant t3) puis les signaux SH et RST sont ramenés aux niveaux précédents en vue de la prochaine exposition.

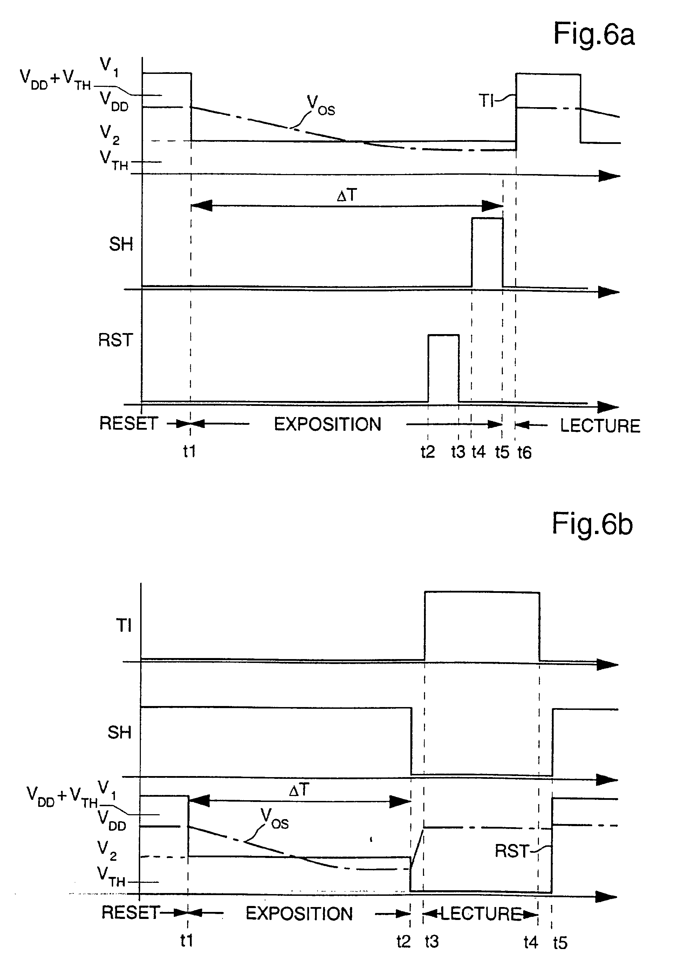

Les variantes qui vont maintenant être présentées en référence aux figures 6a et 6b constituent des variantes avantageuses permettant d'opérer la structure illustrée en figure 2b de manière à ce qu'elle présente une réponse combinée linéaire-logarithmique.

La figure 6a présente ainsi une quatrième variante du procédé selon la présente invention selon laquelle le transistor M1 est configuré de manière à ce qu'il fonctionne au moins partiellement en faible inversion de sorte que le pixel présente, lors de la phase d'exposition de l'élément photo-détecteur, une réponse logarithmique pour des niveaux d'illumination supérieurs à un niveau d'illumination déterminé.

Comme illustré dans le diagramme de la figure 6a, le signal TI appliqué sur le terminal de grille du transistor M1 est commuté entre un premier niveau analogique, désigné V₁, supérieur à la tension d'alimentation V_{DD} plus la tension de seuil, désignée V_{TH}, du transistor M1, et un second niveau analogique, désigné V₂, inférieur ou égal à la tension d'alimentation V_{DD} mais supérieur à la tension de seuil V_{TH} du transistor M1. Le premier niveau analogique V₁ est appliqué durant une phase d'initialisation forçant la tension aux bornes de la photodiode PD à la tension V_{DD}. Le second niveau analogique V₂ est appliqué pour une période de temps déterminée ΔT (instants t1 à t5) durant la phase d'exposition. Selon cette variante, les noeuds A et B du pixel sont découplés durant la phase d'exposition (et durant la phase d'initialisation), le signal SH étant ainsi maintenu à un niveau logique bas. Ce signal SH est brièvement pulsé à un niveau haut au terme de la phase d'exposition (instants t4 à t5) afin d'échantillonner et mémoriser le signal de mesure sur le noeud mémoire B. Avant le passage du signal SH à l'état haut, le signal RST appliqué sur le transistor M3 est également brièvement pulsé à l'état logique haut (instants t2 à t3) de manière à initialiser le noeud mémoire B à une tension d'initialisation déterminée. L'opération de lecture est entreprise en parallèle à une exposition ultérieure, dès lors que le signal de mesure a été mémorisé sur le noeud mémoire B.

Selon cette quatrième variante de l'invention, dès lors que le signal TI est amené de son premier à son second niveau analogique (instant t1), la photodiode PD est tout d'abord libérée de sa tension d'initialisation V_{DD}. A cet instant, la tension grille-source du transistor M1 est telle que ce transistor n'est pas conducteur. La réponse du pixel est ainsi de type linéaire et la tension V_{OS} aux bornes de la photodiode PD décroît linéairement avec une pente dépendant de l'illumination du pixel. Si l'illumination est telle que la tension V_{OS} décroît et devient inférieure à la tension appliquée sur le terminal de grille du transistor M1, à savoir le second niveau analogique V₂ du signal TI, le transistor M1 entre en mode de faible inversion et la réponse du pixel devient alors de type logarithmique. En quelque sorte, une opération de compression du signal est opérée sur le pixel.

La figure 6b présente une cinquième variante du procédé selon la présente invention, analogue à la variante illustrée en figure 6a mais selon laquelle le transistor M3 est configuré de manière à ce qu'il fonctionne au moins partiellement en faible inversion de sorte que le pixel présente, lors de la phase d'exposition de l'élément photo-détecteur, une réponse logarithmique pour des niveaux d'illumination supérieurs à un niveau d'illumination déterminé.

Comme illustré dans le diagramme de la figure 6b, les deux niveaux analogiques V₁ et V₂ sont appliqués sur le terminal de grille du transistor M3 respectivement durant une phase d'initialisation et durant une phase d'exposition pour une période de temps déterminée ΔT (instants t1 à t2). Selon cette variante, les noeuds A et B du pixel sont couplés durant la phase d'exposition, le signal SH étant ainsi maintenu à un niveau logique haut durant cette phase. Ce signal SH est amené à un niveau logique bas (de même que le signal RST) au terme de la phase d'exposition (instants t2 à t5) afin d'isoler le noeud mémoire B et mémoriser le signal de mesure sur ce noeud mémoire B.

En outre, le signal TI appliqué sur le terminal de grille du transistor M1 est préférablement amené à un niveau haut (au moins supérieur à la tension appliquée sur la grille du transistor M2) dès lors que le signal de mesure a été mémorisé sur le noeud mémoire B (instant t3 dans la figure 6b) ceci permettant un drainage, via le transistor M1, des porteurs de charge produits par la photodiode PD.

A partir de l'instant t3, l'opération de lecture peut être entreprise au moyen des transistors M4 et M5. Au terme de l'opération de lecture le signal TI est ramené à son niveau bas (instant t4) puis les signaux SH et RST sont ramenés aux niveaux précédents en vue de la prochaine exposition comme illustré.

De manière analogue à la variante de la figure 6a, selon cette cinquième variante de l'invention, dès lors que le signal RST est amené de son premier à son second niveau analogique (instant t1), la photodiode PD est tout d'abord libérée de sa tension d'initialisation sensiblement égale à V_{DD}. A cet instant, la tension grille-source du transistor M3 est telle que ce transistor n'est pas conducteur. La réponse du pixel est ainsi de type linéaire et la tension V_{OS} aux bornes de la photodiode PD décroît linéairement avec une pente dépendant de l'illumination du pixel, la tension présente sur le noeud mémoire B étant représentative de la tension V_{OS}. Si l'illumination est telle que la tension au noeud mémoire B décroît et devient inférieure à la tension appliquée sur le terminal de grille du transistor M3, à savoir le second niveau analogique V₂ du signal RST, le transistor M3 entre en mode de faible inversion et la réponse du pixel devient alors de type logarithmique, une opération de compression du signal est alors opérée sur le pixel.

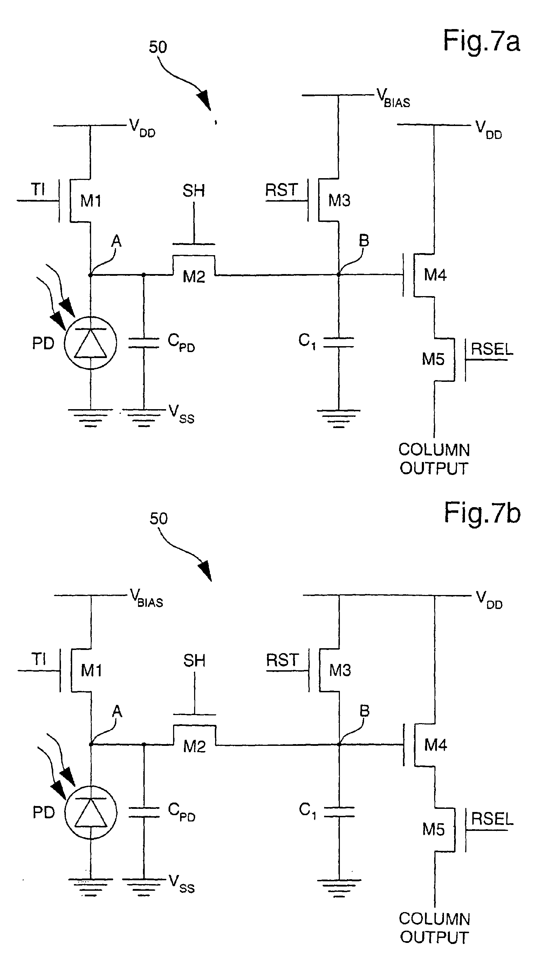

Une variante des principes des figures 6a et 6b peut consister à non pas commuter la tension appliquée sur le terminal de grille du transistor M1 ou M3, mais à commuter la tension appliquée sur le drain de ces transistors. Les figures 7a et 7b illustrent ainsi des première et deuxième variantes de la structure de pixel de la figure 2b pouvant être opérées de sorte qu'elles présentent une réponse combinée linéaire-logarithmique.

La structure de la figure 7a diffère notamment de la structure de la figure 2b en ce que le terminal de drain du transistor M3 est relié à un potentiel d'alimentation V_{BIAS} supérieur au potentiel d'alimentation V_{DD}. La structure de la figure 7b diffère quant à elle de la structure de la figure 2b notamment en ce que le terminal de drain du transistor M1 est relié au potentiel d'alimentation V_{BIAS}.

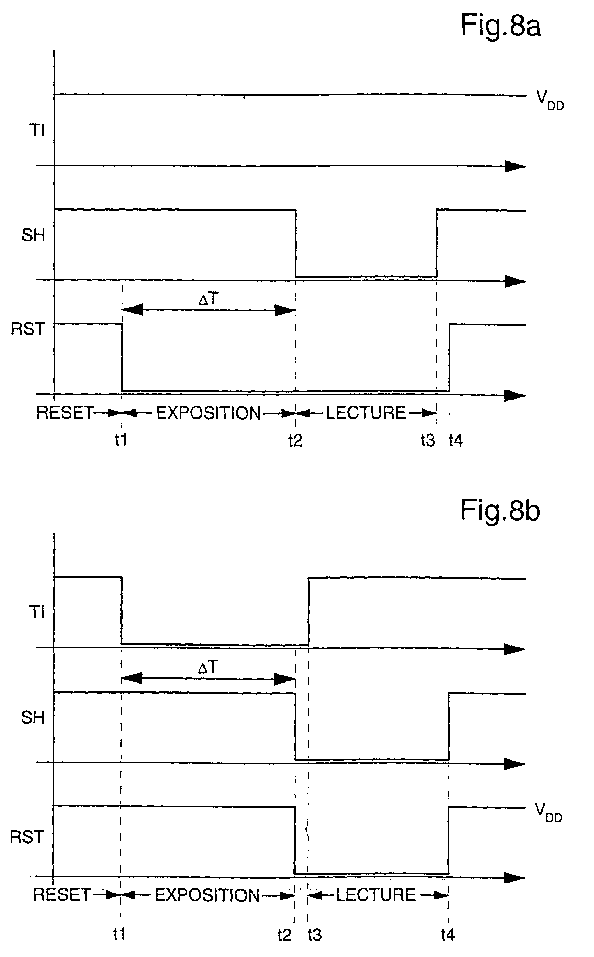

Le diagramme de la figure 8a illustre l'évolution des signaux TI, SH et RST appliqués sur la structure de pixel de la figure 7a. De manière analogue à la variante de la figure 5a, le transistor M1 est branché en continu en configuration de résistance, le terminal de grille de ce transistor M1 étant branché à la tension d'alimentation V_{DD}. Durant une première phase d'initialisation (jusqu'à l'instant t1), le signal RST est amené à son niveau logique haut de manière à appliquer sur le terminal de source du transistor M1 une tension d'initialisation déterminée supérieure à la tension d'alimentation V_{DD}. Durant cette étape d'initialisation, ainsi que durant la phase d'exposition du pixel, le signal SH est maintenu à un niveau logique haut de manière à coupler les noeuds A et B du pixel. Les noeuds A et B sont ainsi tous deux initialisés au moyen du transistor M3.

La phase d'exposition débute par le passage du signal RST au niveau logique bas (instant t1) et se poursuit jusqu'au moment (instant t2) où le signal SH est amené à un niveau logique bas afin d'isoler le noeud mémoire B et ainsi mémoriser le signal de mesure sur ce noeud mémoire B. Durant cette étape d'exposition, le pixel présente une réponse linéaire en fonction de l'illumination et, dès lors que la tension V_{OS} aux bornes de la photodiode PD devient inférieure à la tension de grille du transistor M1 (à savoir la tension V_{DD}), le transistor M1 entre en mode de faible inversion et le pixel présente alors une réponse logarithmique.

A l'instant t2, le signal de mesure est donc mémorisé sur le noeud mémoire B et le processus de lecture peut alors débuter à l'aide des transistors M4 et M5. Dans ce cas, les porteurs de charge produits par la photodiode PD sont drainés via le transistor M1, la tension V_{OS} étant maintenue à son niveau d'équilibre défini par le courant généré par la photodiode PD.

Au terme du processus de lecture (instant t3), le signal SH est ramené à son niveau logique haut précédent, suivi (instant t4) par le signal d'initialisation RST. Le processus entier est alors répété pour l'acquisition suivante.

Le diagramme de la figure 8b illustre l'évolution des signaux TI, SH et RST appliqués sur la structure de pixel de la figure 7b. De manière analogue à la variante de la figure 5c, le transistor M3 est branché en configuration de résistance durant la phase d'exposition, le terminal de grille de ce transistor M3 étant relié à la tension d'alimentation V_{DD}. Durant une première phase d'initialisation (jusqu'à l'instant t1), le signal TI est amené à son niveau logique haut de manière à appliquer, sur le terminal de source du transistor M3 (au noeud mémoire B), une tension d'initialisation déterminée supérieure à la tension d'alimentation V_{DD}. Durant cette étape d'initialisation, le signal SH est maintenu à un niveau logique haut de manière à coupler les noeuds A et B. Les noeuds A et B sont ainsi tous deux initialisés au moyen du transistor M1.

La phase d'exposition débute par le passage du signal TI au niveau logique bas (instant t1) et se poursuit jusqu'au moment (instant t2) où les signaux SH et RST sont amenés à un niveau logique bas afin d'isoler le noeud mémoire B et ainsi mémoriser le signal de mesure sur ce noeud mémoire B. Durant cette étape d'exposition, le pixel présente une réponse linéaire en fonction de l'illumination et, dès lors que la tension du noeud mémoire B devient inférieure à la tension de grille du transistor M3 (à savoir la tension V_{DD}), le transistor entre en mode de faible inversion et le pixel présente alors une réponse logarithmique.

A l'instant t2, le signal de mesure est donc mémorisé sur le noeud mémoire B et le processus de lecture peut alors débuter à l'aide des transistors M4 et M5. Préférablement, aussitôt que le signal de mesure est mémorisé sur le noeud mémoire B, il est avantageux de ramener le signal TI au niveau logique haut (instant t3) afin de drainer les porteurs de charge qui sont produits en continu par la photodiode PD via le transistor M1.

Au terme du processus de lecture (instant t4), les signaux SH et RST sont ramenés à leur niveau précédent et le processus entier est répété pour l'acquisition suivante.

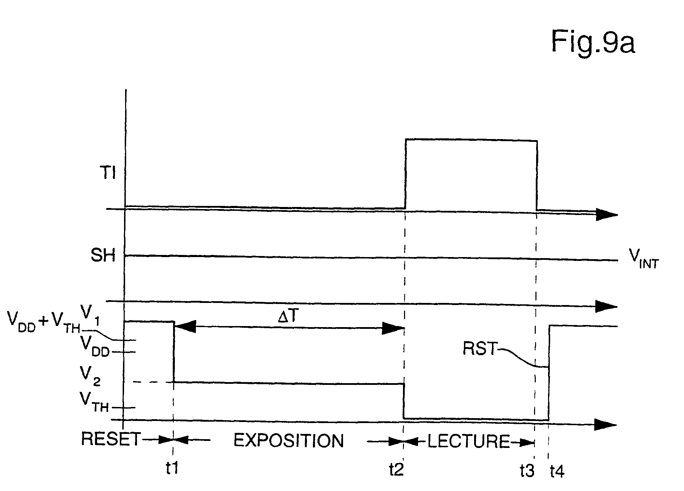

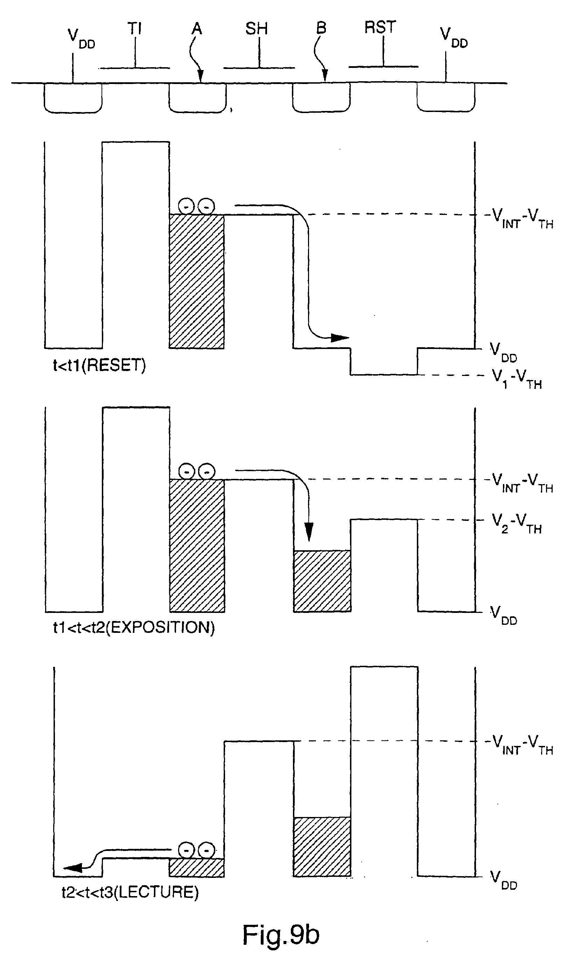

Une variante particulièrement avantageuse du procédé selon la présente invention va maintenant être décrite en référence aux figures 9a et 9b. Outre la fonction d'obturation électronique et l'augmentation de la dynamique du pixel, cette variante permet également d'accroître la sensibilité de ce pixel.

Dans une certaine mesure, cette variante est analogue à la variante illustrée dans la figure 6b, à la différence près que le transistor M2 n'est plus opéré comme commutateur afin de coupler et découpler les noeuds A et B du pixel. Selon cette variante, le signal SH est amené, préférablement en continu, à un niveau analogique intermédiaire, désigné V_{INT}, c'est-à-dire un niveau situé entre les niveaux logiques appliqués normalement pour commuter le transistor M2. Comme on le verra ci-après en détail, ce niveau analogique V_{INT} est choisi inférieur au niveau analogique V₂ appliqué sur le transistor M3 durant l'exposition.

Pour le reste, les signaux TI et RST sont opérés de manière essentiellement similaire à la variante de la figure 6b, comme illustré dans le diagramme de la figure 9a. Dans une première phase d'initialisation, le signal RST est amené à son premier niveau logique V₁ supérieur à la tension d'alimentation V_{DD} plus la tension de seuil V_{TH} du transistor M3, le signal TI étant maintenu à l'état logique bas durant cette phase. La photodiode PD est initialisée via le transistor M3 et le transistor M2 à une tension sensiblement égale à la tension de grille du transistor M2, c'est-à-dire V_{INT}, moins la tension de seuil V_{TH} de ce transistor M2.

L'exposition débute par le passage (instant t1) du signal RST à son second niveau analogique V₂ inférieur ou égal à la tension d'alimentation V_{DD} mais supérieur à la tension de seuil V_{TH}. Durant l'exposition, le signal TI est toujours maintenu à son niveau bas. Les porteurs de charge produits par la photodiode PD sont ainsi intégralement transférés, durant la phase d'exposition, vers le noeud mémoire B et ceci pour autant que le potentiel du noeud mémoire B n'atteint pas le niveau de la barrière de potentiel définie par le transistor M2. Etant donné que ces porteurs de charge ne « voient » que la capacité du noeud mémoire B, ils génèrent une variation de tension plus importante. Par ce mécanisme, la sensibilité du pixel est ainsi augmentée.

A l'instant t2, le signal RST est amené au niveau logique bas afin de découpler le noeud mémoire B de la tension d'alimentation V_{DD} et le signal TI est simultanément amené à un niveau logique haut (au moins plus élevé que la tension de grille appliquée sur le transistor M2) afin d'interrompre l'exposition du pixel, ou plus exactement, l'accumulation des porteurs de charge produits par la photodiode PD. Lorsque le signal TI est au niveau haut, les porteurs de charge produits par la photodiode PD sont drainés via le transistor M1 et le signal de mesure est stocké sur le noeud mémoire B. En quelque sorte, le transistor M1 commandé par le signal TI joue ici le rôle de commande d'obturation similaire à la fonction qui était remplie jusqu'ici par le transistor M2.

On notera qu'il est parfaitement envisageable de commuter le signal SH appliqué sur le transistor M2 à un niveau logique bas afin de découpler les noeuds A et B conformément à ce qui a été présenté plus haut. Toutefois, comme déjà mentionné, il est préférable de commuter le transistor M1 de manière à ce que les porteurs de charge produits par la photodiode PD soient drainés via ce transistor afin de ne pas perturber le signal de mesure stocké sur le noeud mémoire B. Selon la variante préférée illustrée, en commandant le transistor M1 de la sorte, on profite ainsi de la barrière de potentiel générée par la tension V_{INT} appliquée sur le terminal de grille du transistor M2 pour effectuer ce découplage.

L'opération de lecture est entreprise dès lors que le signal TI est amené au niveau logique haut et est suivie par le repassage du signal TI à son niveau bas (instant t3) puis (instant t4) le repassage du signal RST à son premier niveau analogique V₁. Le processus est alors répété selon la chronologie énoncée ci-dessus.

La figure 9b illustre schématiquement le niveau des potentiels définis par les tensions appliquées sur les terminaux de grille des transistors M1, M2 et M3 durant les phases d'initialisation, d'exposition et de lecture.

Ainsi, durant la phase d'initialisation (0 < t < t1), les noeuds A et B sont respectivement initialisés à des tensions sensiblement égales à V_{INT} - V_{TH} et V_{DD}. Durant la phase d'exposition (t1 < t < t2), les porteurs de charge produits par la photodiode PD au noeud A sont intégralement transférés au noeud mémoire B et s'y accumulent. De manière similaire à ce qui a précédemment été décrit, la réponse du pixel est tout d'abord linéaire puis logarithmique si l'illumination est telle que la tension du noeud mémoire B décroît et devient inférieure à la tension de grille du transistor M3, ce dernier entrant alors en mode de faible inversion. Durant la phase de lecture (t2 < t < t3), les porteurs de charge produits par la photodiode PD sont drainés via le transistor M1 et le transfert de ces charges vers le noeud mémoire B est interrompu, ce noeud mémoire étant par ailleurs découplé de la tension d'alimentation V_{DD} par le transistor M3.

Dans les diverses variantes qui ont été présentées ci-dessus, l'opération de lecture peut être effectuée selon une technique connue de l'homme du métier sous la dénomination "Correlated Double Sampling" ou CDS. Selon cette technique connue, l'opération de lecture de chaque ligne se décompose en une première phase de lecture de la tension présente sur les noeuds mémoires B des pixels dans une ligne suivie d'une seconde phase de lecture durant laquelle les noeuds mémoires des pixels dans la ligne sont réinitialisés, en principe au moyen du transistor M3. Un signal formé de la différence entre la tension échantillonnée mesurée et la tension d'initialisation du noeud mémoire est alors produit pour chaque pixel. Cette technique permet la suppression du "bruit stable" ou "fixed pattern noise", c'est-à-dire la suppression du bruit présent sur chaque pixel du capteur et qui est dû aux légères différences de sensibilité qui peuvent exister entre les pixels. Tant le signal de sélection de ligne RSEL que le second signal d'initialisation RST sont ainsi appliqués ligne par ligne durant cette phase de lecture.

Il convient de noter que les variantes présentées emploient soit le transistor M1 ou le transistor M3 (désigné en tant que « premier transistor » dans les revendications) pour générer une réponse au moins partiellement logarithmique. L'autre transistor, c'est-à-dire le transistor qui n'est pas opéré en mode de faible inversion, peut ne pas être nécessaire. Ainsi, la variante de la figure 5a ne nécessite pas obligatoirement la présence du transistor M3. De même, le transistor M1 dans les variantes des figures 5c et 6b n'est pas strictement nécessaire. La présente invention est donc applicable à tout type de structure de pixel ayant une architecture globale telle qu'illustrée dans la figure 2a et qui comporte au moins un transistor connecté, directement ou indirectement, à l'élément photo-détecteur, c'est-à-dire un transistor dont le terminal de drain est connecté à une tension déterminée (par exemple la tension d'alimentation VDD) et dont le terminal de source est connecté soit au noeud A du pixel (un premier terminal du transistor de couplage M2) ou au noeud B du pixel (le deuxième terminal du transistor de couplage M2). La structure de pixel de la figure 2b est cependant particulièrement avantageuse car elle offre une grande flexibilité d'utilisation comme cela est apparent des diverses variantes présentées ci-dessus.

Au titre d'amélioration contre le phénomène de diffusion de porteur de charge dans le substrat, il est préférable de faire appel à des photodiodes de type n-well, c'est-à-dire des photodiodes formées dans des caissons de type n. Cette structure offre l'avantage de constituer un meilleur obstacle à la diffusion de porteurs de charge qu'une structure de photodiode formée conventionnellement, par exemple d'une simple région de diffusion de type n.

De nombreuses modifications et/ou améliorations de la présente invention peuvent être envisagées sans sortir du cadre de l'invention définie par les revendications annexées. En particulier, la structure du pixel utilisée à titre d'exemple pour illustrer le procédé selon la présente invention pourrait dans le principe être réalisée au moyen d'une technologie p-MOS complémentaire ou le cas échéant comprendre des transistors additionnels. On comprendra par exemple que le transistor d'échantillonnage M2 a essentiellement pour rôle de découpler la photodiode et le noeud mémoire du pixel et que d'autres agencements peuvent être prévus pour remplir cette fonction.

## Revendications

1. Procédé permettant d'opérer un capteur d'image CMOS comportant une pluralité de pixels (50), chacun desdits pixels (50) comportant un élément photo-détecteur (PD) produisant des porteurs de charge en proportion de son illumination et un moyen de stockage (C1) susceptible d'être couplé et découplé dudit élément photo-détecteur (PD) à un instant déterminé afin de mémoriser, sur un noeud mémoire (B) dudit pixel (50), un signal de mesure représentatif desdits porteurs de charge produits par ledit élément photo-détecteur (PD) durant une phase d'exposition,
chaque pixel comprenant au moins un transistor MOS (M1 ; M3) connecté en série par ses terminaux de drain ou de source au dit élément photo-détecteur (PD),
**caractérisé en ce que** ledit transistor MOS (M1 ; M3) est configuré de manière à ce qu'il fonctionne au moins partiellement en faible inversion de sorte que le pixel (50) présente, lors de ladite phase d'exposition dudit élément photo-détecteur (PD), une réponse logarithmique pour des niveaux d'illumination supérieurs à un niveau d'illumination déterminé.

2. Procédé selon la revendication 1, dans lequel chaque pixel (50) comporte :
- une photodiode (PD) polarisée inverse formant ledit élément photo-détecteur ;
- un moyen de couplage (M2) comprenant des premier et deuxième terminaux pour coupler et découpler ladite photodiode (PD) et ledit moyen de stockage (C1); et
- au moins un premier transistor MOS (M1) comprenant des terminaux de grille, de source et de drain,
ladite photodiode (PD) étant connectée, d'une part, à une première tension d'alimentation (V_{SS}) et, d'autre part, au premier terminal dudit moyen de couplage (M2) et au terminal de source dudit premier transistor (M1), le terminal de drain dudit premier transistor (M1) étant connecté à une seconde tension d'alimentation (V_{DD}), le deuxième terminal dudit moyen de couplage (M2) étant connecté au dit noeud mémoire (B) du moyen de stockage (C1),
**caractérisé en ce que** ledit premier transistor (M1) est configuré pour fonctionner au moins partiellement en faible inversion.

3. Procédé selon la revendication 2, **caractérisé en ce qu'**il comprend les étapes suivantes :
a) une étape d'exposition consistant à brancher ledit premier transistor (M1) en configuration de résistance en connectant son terminal de grille à ladite seconde tension d'alimentation (V_{DD}), ladite photodiode (PD) et ledit moyen de stockage (C1) étant couplés ensemble à l'aide dudit moyen de couplage (M2) ;
b) une étape de mémorisation consistant à découpler ladite photodiode (PD) et ledit moyen de stockage (C1), ledit signal de mesure étant alors mémorisé sur ledit noeud mémoire (B) ; et
c) une étape de lecture consistant à opérer la lecture dudit signal de mesure mémorisé sur ledit noeud mémoire (B).

4. Procédé selon la revendication 2, **caractérisé en ce qu'**il comprend les étapes suivantes :
a) une étape d'exposition consistant à brancher ledit premier transistor (M1) en configuration de résistance en connectant son terminal de grille à ladite seconde tension d'alimentation (V_{DD}), ladite photodiode (PD) et ledit moyen de stockage (C1) étant découplés à l'aide dudit moyen de couplage (M2) ;
b) une étape de mémorisation consistant à brièvement coupler ladite photodiode (PD) et ledit moyen de stockage (C1) à l'aide dudit moyen de couplage (M2) afin de mémoriser ledit signal de mesure sur ledit noeud mémoire (B) ; et
c) une étape de lecture consistant à opérer la lecture dudit signal de mesure mémorisé sur ledit noeud mémoire (B).

5. Procédé selon la revendication 2, **caractérisé en ce qu'**il comprend les étapes suivantes :
a) une étape d'initialisation consistant à appliquer, sur le terminal de grille dudit premier transistor (M1), une tension (V₁) supérieure à ladite seconde tension d'alimentation (V_{DD}) plus la tension de seuil (V_{TH}) dudit premier transistor (M1), ladite photodiode (PD) et ledit moyen de stockage (C1) étant découplés à l'aide dudit moyen de couplage (M2) ;
b) une étape d'exposition, de durée déterminée (ΔT), consistant à appliquer, sur le terminal de grille dudit premier transistor (M1), une tension (V₂) inférieure ou égale à ladite seconde tension d'alimentation (V_{DD}) mais supérieure à ladite première tension d'alimentation (V_{SS}) plus la tension de seuil (V_{TH}) dudit premier transistor (M1), ladite photodiode (PD) et ledit moyen de stockage (C1) étant découplés ;
c) une étape de mémorisation consistant à brièvement coupler ladite photodiode (PD) et ledit moyen de stockage (C1) à l'aide dudit moyen de couplage (M2) afin de mémoriser ledit signal de mesure sur ledit noeud mémoire (B) ; et
d) une étape de lecture consistant à opérer la lecture dudit signal de mesure mémorisé sur ledit noeud mémoire (B).

6. Procédé selon la revendication 4 ou 5, **caractérisé en ce que** chaque pixel (50) comporte en outre un second transistor MOS (M3) comprenant des terminaux de grille, de source et de drain, les terminaux de source et de drain de ce second transistor (M3) étant respectivement connectés au dit noeud mémoire (B) et à ladite seconde tension d'alimentation (V_{DD}),
et **en ce que** l'étape de mémorisation est précédée d'une étape d'initialisation consistant à initialiser ledit noeud mémoire (B) à une tension d'initialisation déterminée au moyen dudit second transistor (M3).

7. Procédé selon la revendication 2, **caractérisé en ce que** chaque pixel (50) comporte en outre un second transistor MOS (M3) comprenant des terminaux de grille, de source et de drain, les terminaux de source et de drain de ce second transistor (M3) étant respectivement connectés au dit noeud mémoire (B) et à une troisième tension d'alimentation (V_{BIAS}) supérieure à ladite seconde tension d'alimentation (V_{DD}),
et **en ce que** ledit premier transistor (M1) est branché en configuration de résistance en connectant son terminal de grille à ladite seconde tension d'alimentation (V_{DD}), le procédé comprenant les étapes suivantes :
a) une étape d'initialisation consistant à coupler ladite photodiode (PD) et ledit moyen de stockage (C1) à l'aide dudit moyen de couplage (M2) et à rendre conducteur ledit second transistor (M3) pour initialiser le terminal de source dudit premier transistor (M1) à une tension d'initialisation déterminée supérieure à ladite seconde tension d'alimentation (V_{DD}) ;
b) une étape d'exposition, de durée déterminée (ΔT), consistant à rendre non conducteur ledit second transistor (M3) et à maintenir couplés ladite photodiode (PD) et ledit moyen de stockage (C1) ;
c) une étape de mémorisation consistant à découpler ladite photodiode (PD) et ledit moyen de stockage (C1), et à maintenir ledit second transistor (M3) à l'état non conducteur, ledit signal de mesure étant alors mémorisé sur ledit noeud mémoire (B) ; et
d) une étape de lecture consistant à opérer la lecture dudit signal de mesure mémorisé sur ledit noeud mémoire (B).

8. Procédé selon la revendication 1, dans lequel chaque pixel (50) comporte :
- une photodiode (PD) polarisée inverse formant ledit élément photo-détecteur ;
- un moyen de couplage (M2) comprenant des premier et deuxième terminaux pour coupler et découpler ladite photodiode (PD) et ledit moyen de stockage (C1) ; et
- au moins un premier transistor MOS (M3) comprenant des terminaux de grille, de source et de drain,
ladite photodiode (PD) étant connectée, d'une part, à une première tension d'alimentation (V_{SS}) et, d'autre part, au premier terminal dudit moyen de couplage (M2), le terminal de drain dudit premier transistor (M3) étant connecté à une seconde tension d'alimentation (V_{DD}), le deuxième terminal dudit moyen de couplage (M2) étant connecté au dit noeud mémoire (B) du moyen de stockage (C1) et au terminal de source dudit premier transistor (M3),
**caractérisé en ce que** ledit premier transistor (M3) est configuré pour fonctionner au moins partiellement en faible inversion.

9. Procédé selon la revendication 8, **caractérisé en ce qu'**il comprend les étapes suivantes :
a) une étape d'exposition consistant à brancher ledit premier transistor (M3) en configuration de résistance en connectant son terminal de grille à ladite seconde tension d'alimentation (V_{DD}), ladite photodiode (PD) et ledit moyen de stockage (C1) étant couplés ensemble à l'aide dudit moyen de couplage (M2) ;
b) une étape de mémorisation consistant à découpler ladite photodiode (PD) et ledit moyen de stockage (C1) et à appliquer une tension sur le terminal de grille du premier transistor (M3) telle que ce transistor n'est pas conducteur, ledit signal de mesure étant alors mémorisé sur ledit noeud mémoire (B) ; et
c) une étape de lecture consistant à opérer la lecture dudit signal de mesure mémorisé sur ledit noeud mémoire (B).

10. Procédé selon la revendication 8, **caractérisé en ce qu'**il comprend les étapes suivantes :
a) une étape d'initialisation consistant à appliquer, sur le terminal de grille dudit premier transistor (M3), une tension (V₁) supérieure à ladite seconde tension d'alimentation (V_{DD}) plus la tension de seuil (V_{TH}) dudit premier transistor (M3), ladite photodiode (PD) et ledit moyen de stockage (C1) étant couplés ensemble à l'aide dudit moyen de couplage (M2) ;
b) une étape d'exposition, de durée déterminée (ΔT), consistant à appliquer, sur le terminal de grille dudit premier transistor (M3), une tension (V₂) inférieure ou égale à ladite seconde tension d'alimentation (V_{DD}) mais supérieure à ladite première tension d'alimentation (V_{SS}) plus la tension de seuil (V_{TH}) dudit premier transistor (M3), ladite photodiode (PD) et ledit moyen de stockage (C1) étant couplés ensemble ;
c) une étape de mémorisation consistant à découpler ladite photodiode (PD) et ledit moyen de stockage (C1) et à appliquer une tension sur le terminal de grille du premier transistor (M3) telle que ce transistor n'est pas conducteur, ledit signal de mesure étant alors mémorisé sur ledit noeud mémoire (B) ; et
d) une étape de lecture consistant à opérer la lecture dudit signal de mesure mémorisé sur ledit noeud mémoire (B).

11. Procédé selon la revendication 10, **caractérisé en ce que** ledit moyen de couplage est un transistor MOS de couplage (M2) comprenant des terminaux de grille, de source et de drain, lesdits terminaux de source et de drain de ce transistor de couplage (M2) étant respectivement connectés à ladite photodiode (PD) et au dit noeud mémoire (B),
et **en ce que** le terminal de grille dudit transistor de couplage (M2) est maintenu, au moins durant les étapes d'initialisation a) et d'exposition b), à une tension (V_{INT}) inférieure à la tension (V₂) appliquée sur le terminal de grille dudit premier transistor (M3) durant l'étape d'exposition.

12. Procédé selon l'une quelconque des revendications 9 à 11, **caractérisé en ce que** chaque pixel (50) comporte en outre un second transistor MOS (M1) comprenant des terminaux de grille, de source et de drain, les terminaux de source et de drain de ce second transistor (M1) étant respectivement connectés à ladite photodiode (PD) et à ladite seconde tension d'alimentation (V_{DD}),
et **en ce que** lors de ladite étape de lecture, on applique une tension sur le terminal de grille du second transistor (M1) telle que les porteurs de charge produits par ladite photodiode (PD) sont drainés via ce second transistor (M1).

13. Procédé selon la revendication 8, **caractérisé en ce que** chaque pixel (50) comporte en outre un second transistor MOS (M1) comprenant des terminaux de grille, de source et de drain, les terminaux de source et de drain de ce second transistor (M1) étant respectivement connectés à ladite photodiode (PD) et à une troisième tension d'alimentation (V_{BIAS}) supérieure à ladite seconde tension d'alimentation (V_{DD}),
et **en ce que** ledit premier transistor (M3) est branché en configuration de résistance en connectant son terminal de grille à ladite seconde tension d'alimentation (V_{DD}), le procédé comprenant les étapes suivantes :
a) une étape d'initialisation consistant à coupler ladite photodiode (PD) et ledit moyen de stockage (C1) à l'aide dudit moyen de couplage (M2) et à rendre conducteur ledit second transistor (M1) pour initialiser le terminal de source dudit premier transistor (M3) à une tension d'initialisation déterminée supérieure à ladite seconde tension d'alimentation (V_{DD}) ;
b) une étape d'exposition, de durée déterminée (ΔT), consistant à rendre non conducteur ledit second transistor (M1) et à maintenir couplés ladite photodiode (PD) et ledit moyen de stockage (C1);
c) une étape de mémorisation consistant à découpler ladite photodiode (PD) et ledit moyen de stockage (C1), à maintenir ledit second transistor (M1) à l'état non conducteur et à rendre non conducteur ledit premier transistor (M3), ledit signal de mesure étant alors mémorisé sur ledit noeud mémoire (B) ; et
d) une étape de lecture consistant à opérer la lecture dudit signal de mesure mémorisé sur ledit noeud mémoire (B).

14. Procédé selon l'une quelconque des revendications 2 à 10 ou 13, **caractérisé en ce que** ledit moyen de couplage est un transistor MOS (M2) comprenant des terminaux de grille, de source et de drain, lesdits terminaux de source et de drain de ce transistor (M2) étant respectivement connectés à ladite photodiode (PD) et au dit noeud mémoire (B).

15. Capteur d'image CMOS comportant une pluralité de pixels (50), chacun desdits pixels (50) comportant un élément photo-détecteur (PD) produisant des porteurs de charge en proportion de son illumination et un moyen de stockage (C1) susceptible d'être couplé et découplé dudit élément photo-détecteur (PD) à un instant déterminé afin de mémoriser, sur ledit moyen de stockage (C1), un signal de mesure représentatif desdits porteurs de charge produits par ledit élément photo-détecteur (PD) durant une phase d'exposition,
chaque pixel comprenant au moins un transistor MOS (M1, M3) connecté en série par ses terminaux de drain ou de source au dit élément photo-détecteur (PD),
**caractérisé en ce que** ledit transistor MOS (M1, M3) est configuré de manière à ce qu'il fonctionne au moins partiellement en faible inversion de sorte que le pixel présente, lors de ladite phase d'exposition dudit élément photo-détecteur, une réponse logarithmique pour des niveaux d'illumination supérieurs à un niveau d'illumination déterminé.

16. Capteur d'image selon la revendication 15, dans lequel chaque pixel (50) comporte :
- une photodiode (PD) polarisée inverse formant ledit élément photo-détecteur ;
- un moyen de couplage (M2) comprenant des premier et deuxième terminaux pour coupler et découpler ladite photodiode (PD) et ledit moyen de stockage (C1) ; et
- au moins un premier transistor MOS (M1 ; M3) comprenant des terminaux de grille, de source et de drain,
ladite photodiode (PD) étant connectée, d'une part, à une première tension d'alimentation (V_{SS}) et, d'autre part, au premier terminal du moyen de couplage (M2), le terminal de drain dudit premier transistor (M1 ; M3) étant connecté à une seconde tension d'alimentation (V_{DD}), le deuxième terminal dudit moyen de couplage (M2) étant connecté au dit noeud mémoire (B) du moyen de stockage (C1), et le terminal de source dudit premier transistor (M1 ; M3) étant connecté au dit premier ou deuxième terminal dudit moyen de couplage (M2),
**caractérisé en ce que** ledit premier transistor (M1 ; M3) est configuré pour fonctionner au moins partiellement en faible inversion.

17. Capteur d'image selon la revendication 16, **caractérisé en ce que** ledit capteur comprend des moyens pour commuter la tension de grille dudit premier transistor (M1 ; M3) entre des première (V₁) et seconde (V₂) tensions respectivement supérieure à ladite seconde tension d'alimentation (V_{DD}) plus la tension de seuil (V_{TH}) dudit premier transistor (M1 ; M3) et inférieure ou égale à ladite seconde tension d'alimentation (V_{DD}) mais supérieure à ladite première tension d'alimentation (V_{SS}) plus la tension de seuil (V_{TH}) dudit premier transistor (M1 ; M3).

18. Capteur d'image selon la revendication 16, **caractérisé en ce que** chaque pixel (50) comporte en outre un second transistor MOS (M3 ; M1) comprenant des terminaux de grille, de source et de drain, les terminaux de drain et de source de ce second transistor (M3 ; M1) étant respectivement connectés au dit premier ou deuxième terminal dudit moyen de couplage (M2) et à une troisième tension d'alimentation (V_{BIAS}) supérieure à ladite seconde tension d'alimentation (V_{DD}),
ledit second transistor (M3 ; M1) formant un moyen d'initialisation pour initialiser le terminal de source dudit premier transistor (M1 ; M3) à une tension déterminée supérieure à ladite seconde tension d'alimentation (V_{DD}).

19. Capteur d'image selon l'une quelconque des revendications 15 à 18, **caractérisé en ce que** la photodiode (PD) est formée dans un caisson de type n et **en ce que** lesdits transistors (M1 à M3; M1 à M5) sont des transistors n-MOS.

20. Capteur d'image selon l'une quelconque des revendications 15 à 19, **caractérisé en ce que** ledit moyen de stockage (C1) est formé d'une capacité protégée de la lumière par une couche métallique.
